# DEMANDE DE BREVET EUROPEEN

(11) **EP 0 993 028 A1**
(43) Date de publication de la demande: **12.04.2000**
(21) Numéro de dépôt: 99410126.9
(22) Date de dépôt: 06.10.1999
(51) Int. Cl.: H01L 21/205

(54) **Procédé d'épitaxie sur un substrat de silicium comprenant des zones fortement dopées au bore**

(30) Priorité: 07.10.1998 FR 9812755
(71) Demandeur: STMicroelectronics S.A., 94250 Gentilly (FR); FRANCE TELECOM, 75015 Paris (FR)
(72) Inventeur: Dutartre, Didier, 38240 Meylan (FR); Jerier, Patrick, 38100 Grenoble (FR)
(74) Mandataire: de Beaumont, Michel

(57) **Abrégé**

L'invention concerne un procédé de dépôt par épitaxie en phase gazeuse de silicium sur un substrat de silicium (1) sur ou dans lequel existent des zones (6, 7) contenant des dopants à forte concentration, dont du bore, en évitant un autodopage de la couche épitaxiée par le bore, comprenant l'étape consistant à introduire un gaz chloré, avant l'étape de dépôt épitaxial de façon à graver le substrat sur une épaisseur inférieure à 100 nm.

## Description

La présente invention concerne la fabrication des composants semiconducteurs et plus particulièrement le dépôt par épitaxie d'une couche de silicium sur un substrat de silicium monocristallin.

De façon générale, dans le domaine de la fabrication des composants semiconducteurs, il est connu de faire croître des couches épitaxiées d'un type de conductivité et d'un niveau de dopage déterminés sur des substrats d'un type de conductivité déterminé, généralement différent de celui de la couche épitaxiée, et d'un niveau de dopage déterminé. L'épitaxie permet d'obtenir des couches minces monocristallines dont le niveau de dopage est contrôlable sur leur épaisseur, contrairement aux procédés impliquant une étape de diffusion de dopants, dans lesquels le niveau de dopage décroît avec la profondeur de diffusion.

Les procédés d'épitaxie en phase gazeuse, développés depuis de nombreuses années, fonctionnent de façon tout à fait satisfaisante quand le niveau de dopage du substrat est homogène et relativement faible. Par contre, dans les technologies modernes, on utilise de plus en plus des couches enterrées, c'est-à-dire des couches localisées fortement dopées du premier et/ou du second type de conductivité formées sous la couche épitaxiée. Ces couches enterrées sont obtenues en réalisant dans le substrat une implantation à dose élevée d'un dopant choisi avant de réaliser la croissance épitaxiale. Ces couches sont par exemple destinées à former des collecteurs de transistors bipolaires et doivent être très fortement dopées. Il en résulte un inconvénient connu, couramment désigné par le terme autodopage, qui est que le dopant implanté tend, lors du procédé d'épitaxie, à doper la couche épitaxiée au-dessus et à côté de la région implantée. La couche épitaxiée n'a alors plus la résistivité souhaitée. Cet inconvénient est d'autant plus marqué que la couche épitaxiée est mince puisque le phénomène d'autodopage se produit essentiellement pendant la phase initiale de croissance de cette couche. En outre, il apparaît à l'évidence que le taux d'autodopage de la couche épitaxiée dépend de la surface des zones dopées destinées à devenir des couches enterrées. Plus cette surface est importante, plus l'autodopage est important. Ainsi, d'un circuit à l'autre, selon que l'on a réalisé plus ou moins de couches enterrées, la couche épitaxiée n'aura pas la même résistivité d'ensemble. Ce phénomène est difficilement maîtrisable. Ceci s'oppose à ce que l'on recherche dans tout procédé industriel, à savoir obtenir des résultats contrôlés et répétitifs, et si possible identiques pour différents produits d'une technologie donnée.

A ce jour, de nombreux procédés ont été proposés pour tenter de résoudre les problèmes d'autodopage lors du dépôt d'une couche épitaxiale faiblement dopée sur un substrat contenant des zones implantées au bore, ou des zones implantées au bore et des zones implantées à l'arsenic. Toutefois ces procédés ont donné des résultats plus ou moins satisfaisants selon les conditions de fonctionnement et aucun n'a recueilli à ce jour un consensus général. En outre, si certaines solutions proposées ont permis de réduire l'autodopage dû au bore, elles ont empiré l'autodopage dû à d'autres dopants tels que l'arsenic et, dans le cas où il existe des sources de dopants de divers types, le résultat global n'est pas satisfaisant.

Ainsi, la présente invention vise un procédé de dépôt épitaxial de silicium sur un substrat de silicium dans lequel, ou au-dessus duquel, existent des régions fortement dopées au bore et éventuellement également à l'arsenic.

Pour atteindre cet objet, la présente invention prévoit un procédé de dépôt par épitaxie en phase gazeuse de silicium sur un substrat de silicium sur ou dans lequel existent des zones contenant des dopants à forte concentration dont du bore, en évitant un autodopage de la couche épitaxiée par le bore, comprenant les étapes consistant à :
a) effectuer optionnellement un recuit initial ;
b) procéder à un dépôt épitaxial pendant une durée choisie pour obtenir une épaisseur totale souhaitée ;
c) introduire un gaz chloré, avant l'étape de dépôt épitaxial de façon à graver le substrat sur une épaisseur faible, inférieure à 100 nm.

Selon un mode de réalisation de la présente invention, le gaz chloré est HCl.

Selon un mode de réalisation de la présente invention, le gaz chloré est introduit pendant une durée limitée avant le dépôt épitaxial.

Selon un mode de réalisation de la présente invention, le gaz chloré est introduit pendant la majeure partie du recuit initial.

Selon un mode de réalisation de la présente invention, le recuit initial est réalisé à une température de l'ordre de 1100°C et le dépôt épitaxial à une température de l'ordre de 1050°C.

Selon un mode de réalisation de la présente invention, le recuit initial est réalisé en présence d'hydrogène.

Selon un mode de réalisation de la présente invention, le dépôt épitaxial est réalisé en présence d'une source de bore.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1 et 2 illustrent schématiquement un procédé d'épitaxie avec formation de couches enterrées ;
la figure 3 illustre une séquence de réalisation d'une épitaxie ;
la figure 4A est une vue de dessus d'une plaquette de test et la figure 4B illustre des résultats comparés d'autodopage au bore dans des couches épitaxiées formées selon un procédé classique et selon le procédé de l'invention ; et
la figure 5 illustre schématiquement une explication possible de l'autodopage par du bore.

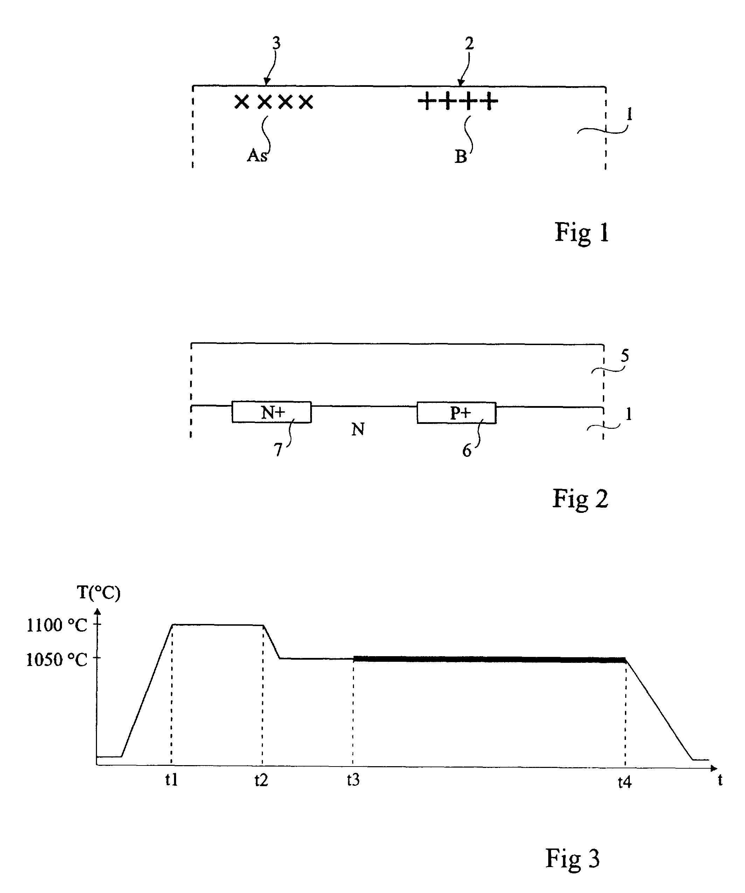

De façon classique, pour former une couche épitaxiée sur un substrat de silicium monocristallin 1, comme le représente la figure 1, on commence par former dans le substrat 1 des zones 2 et 3 dans lesquelles sont réalisées des implantations à forte dose de dopants destinées à constituer des couches enterrées. Dans l'exemple représenté, la zone 2 contient du bore et la zone 3 de l'arsenic.

Ensuite, comme le représente la figure 2, on développe par épitaxie une couche de silicium monocristallin 5 et les zones 2 et 3 correspondent alors respectivement à des couches enterrées 6 et 7. La croissance épitaxiale s'effectue par exemple sous faible pression en présence d'hydrogène et d'un composé du silicium tel que le dichlorosilane ou le trichlorosilane et en présence d'un composé d'un dopant, par exemple de la phosphine pour former une couche de type N dopée au phosphore. Le problème posé est que le dopage de la couche épitaxiée est influencé par les exodiffusions en provenance des couches enterrées.

La figure 3 illustre, à titre d'exemple, une séquence thermique classique, à deux paliers de température, utilisée lors d'une épitaxie. On commence à monter en température dans un réacteur d'épitaxie, pour atteindre à un instant t₁ une température désirée, généralement plus élevée que la température prévue pour le dépôt, par exemple 1100°C, en présence d'hydrogène à faible pression, par exemple 60 torrs (environ 104 Pa). On maintient la température pendant une certaine durée, jusqu'à un instant t₂, après quoi on descend à la température choisie pour le dépôt épitaxial, par exemple 1050°C, et on attend que la température se stabilise jusqu'à un instant t₃, puis on procède au dépôt proprement dit en présence d'hydrogène et par exemple de dichlorosilane jusqu'à un instant t₄. La durée t₃-t₄ est choisie, en fonction des pressions partielles des gaz, pour obtenir un dépôt d'épaisseur choisie. Après quoi, on redescend en température à un rythme également déterminé. On trouvera dans la littérature de nombreuses descriptions d'un tel procédé.

La présente invention prévoit, avant l'épitaxie proprement dite, c'est-à-dire avant l'instant t₃, d'introduire dans le réacteur d'épitaxie un composé chloré propre à graver une région superficielle du substrat. Ce composé chloré sera par exemple HCl. La pression partielle du gaz chloré et la durée de l'opération seront choisies de façon à obtenir une faible gravure, inférieure à 100 nm de la surface du substrat de silicium. Par exemple, en utilisant une pression partielle de 15 Pa de HCl dans de l'hydrogène à une pression partielle de 10000 Pa, on grave 5 nm de silicium en une minute à 1100°C.

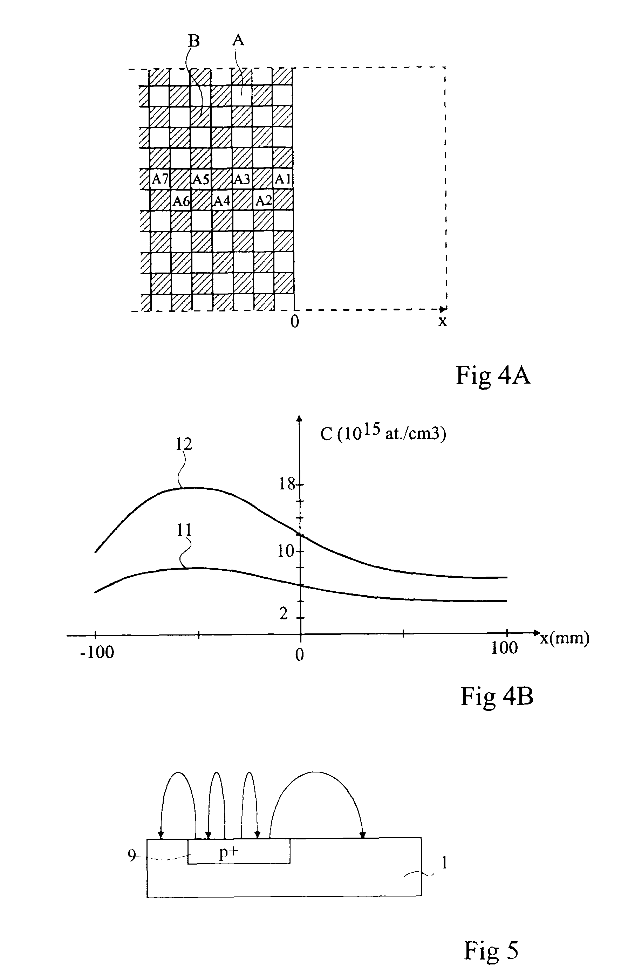

La figure 4A est une vue de dessus d'une plaquette de test réalisée spécialement pour analyser l'efficacité du procédé selon la présente invention. Avant l'épitaxie, la plaquette est divisée en deux parties, une première partie, à droite dans la figure, où aucune implantation n'est réalisée, et une deuxième partie, à gauche dans la figure où est réalisé un damier de zones A, non implantées, et de zones B ayant subi une forte implantation de bore. On désigne par A1 à A7 des "cases" non-implantées du damier s'étendant à partir de la limite entre les parties droite et gauche de la figure. Dans un exemple de réalisation, la plaquette a un diamètre de 200 mm et chaque case du damier a une dimension de 10 x 10 mm.

La figure 4B illustre des résultats comparés d'autodopage au bore dans des couches épitaxiées formées selon un procédé classique et selon le procédé de l'invention au-dessus de la plaquette de la figure 4A. On compare les résistivités mesurées à partir de la surface de la plaquette au-dessus de zones non-implantées. Il est clair que l'influence des zones implantées augmente quand on se déplace de la case A1 vers la case A7.

On constate que la variation de conductivité (convertie dans la figure en concentration de dopants) est beaucoup plus faible avec le procédé selon la présente invention (courbe 11) qu'avec le procédé classique (courbe 12). Des mesures similaires effectuées avec une plaquette de test semblable à celle de la figure 4A, mais dans laquelle les zones dopées ont subi une implantation d'arsenic, n'ont pas montré de différence nette entre le procédé classique et le procédé selon l'invention.

Ainsi, le résultat visé est obtenu, à savoir que l'autodopage par le bore est réduit tandis que l'autodopage par l'arsenic n'est pas dégradé.

On va donner maintenant une explication des phénomènes qui conduisent à ce résultat de l'avis actuel des inventeurs. Il sera toutefois clair que, même si cette explication théorique s'avère erronée ou incomplète, ceci ne saurait affecter la portée de l'invention dont les résultats ont été démontrés.

La figure 5 représente schématiquement un substrat 1 dans lequel on a implanté des atomes de bore 9. La demanderesse considère que dès le début d'un chauffage, des atomes de bore exodiffusent à partir de la surface de la zone implantée dans le gaz, se répartissent sur toute la surface du substrat et pénètrent légèrement dans celui-ci pour former une couche mince dopée au bore, ce qui constitue la couche autodopée. Suivant les échantillons et les conditions opératoires, cette couche peut d'ailleurs imposer son type de conductivité, par trous, et inverser le type de conductivité si les zones inférieure (substrat) et supérieure (couche épitaxiée) sont de type N.

Le procédé selon la présente invention permet d'éliminer la couche mince autodopée et donc de réduire considérablement l'autodopage. Il est également vraisemblable que ce procédé permet aussi d'éliminer du bore présent sur les parois du réacteur. On notera que la gravure selon l'invention est destinée à éliminer la couche mince autodopée dont l'épaisseur est extrêmement variable selon les conditions opératoires. Ainsi, dans certains cas, une gravure sur quelques nanomètres sera suffisante.

Bien entendu, la présente invention est susceptible de diverses variantes et modifications qui apparaîtront à l'homme de l'art. Par exemple, si l'on veut que le nouveau processus reste aussi compatible que possible avec les procédés antérieurs, on pourra prévoir un dopage volontaire au bore des couches épitaxiales formées, de sorte que ces couches aient sensiblement le même comportement que les couches épitaxiales antérieures formées sans utiliser l'invention. Toutefois, on aura alors l'avantage que ce dopage sera parfaitement contrôlé et ne variera pas sur la surface de la puce. Ce dopage au bore peut résulter d'une addition de diborane à la phosphine généralement utilisée.

Des exemples de mise en oeuvre de la présente invention ont été donnés dans le cas où du bore est présent dans une couche enterrée. La présente invention s'appliquera également dans le cas où le bore est présent dans une couche, de silicium polycristallin ou de diélectrique, formée au-dessus du substrat.

La présente invention s'applique aussi dans d'autres conditions d'épitaxie, par exemple quand le recuit initial se fait à la même température (900 à 1100°C) que la température d'épitaxie ou encore quand l'épitaxie commence pendant la montée en température du réacteur. On pourra aussi appliquer l'invention dans le cadre d'épitaxies à basse température, par exemple des épitaxies à des températures de l'ordre de 600°C avec ou sans recuit initial dans une plage de 800 à 900°C.

## Revendications

1. Procédé de dépôt par épitaxie en phase gazeuse de silicium sur un substrat de silicium (1) sur ou dans lequel existent des zones (6, 7) contenant des dopants à forte concentration, dont du bore, en évitant un autodopage de la couche épitaxiée par le bore, caractérisé en ce qu'il comprend, avant l'étape de dépôt épitaxial et tandis que le substrat est à haute température, l'étape consistant à introduire un gaz chloré de façon à graver le substrat sur une épaisseur inférieure à 100 nm.

2. Procédé selon la revendication 1, caractérisé en ce qu'il comprend une étape initiale de recuit.

3. Procédé selon la revendication 2, caractérisé en ce que l'étape initiale de recuit se limite à une phase de montée en température.

4. Procédé selon la revendication 1, caractérisé en ce que le gaz chloré est HCl.

5. Procédé selon la revendication 1, caractérisé en ce que le gaz chloré est introduit pendant une durée limitée avant le dépôt épitaxial.

6. Procédé selon la revendication 1, caractérisé en ce que le gaz chloré est introduit pendant la majeure partie du recuit initial.

7. Procédé selon la revendication 1, caractérisé en ce que le recuit initial est réalisé à une température de l'ordre de 1100°C et le dépôt épitaxial à une température de l'ordre de 1050°C.

8. Procédé selon la revendication 1, caractérisé en ce que le recuit initial est réalisé en présence d'hydrogène.

9. Procédé selon la revendication 1, caractérisé en ce que le dépôt épitaxial est réalisé en présence d'une source de bore.

10. Procédé selon la revendication 1, caractérisé en ce que le dépôt épitaxial est réalisé à une température basse, de l'ordre de 600°C.
